# EUROPEAN PATENT SPECIFICATION

(11) **EP 3 926 127 B1**
(45) Date of publication and mention of the grant of the patent: **03.05.2023**
(21) Application number: 20843568.5
(22) Date of filing: 28.03.2020
(51) Int. Cl.: E04H 5/00, E04B 1/12, B65D 90/02

(54) **CONTAINER UNIT, CONTAINER ASSEMBLY, AND DATA CENTER**
BEHÄLTEREINHEIT, BEHÄLTERANORDNUNG UND DATENZENTRUM
UNITÉ CONTENEUR, ENSEMBLE CONTENEUR ET CENTRE DE DONNÉES

(30) Priority: 19.07.2019 CN 201910657453
(43) Date of publication of application: 22.12.2021
(73) Proprietor: Huawei Digital Power Technologies Co., Ltd., Shenzhen, Guangdong 518043 (CN)
(72) Inventor: HU, Xiong, Shenzhen, Guangdong 518129 (CN); JIAN, Wei, Shenzhen, Guangdong 518129 (CN); CHEN, Jijun, Shenzhen, Guangdong 518129 (CN)
(74) Representative: Pfenning, Meinig & Partner mbB
(86) International application number: PCT/CN2020/081928
(87) International publication number: WO 2021/012703

(56) References cited:
- EP-A1- 3 456 903
- WO-A1-2005/038155
- WO-A1-2010/094459
- CN-A- 102 264 612
- CN-A- 107 905 577
- CN-A- 108 729 552
- CN-A- 110 395 497
- GB-A- 2 550 184
- US-A1- 2014 196 394
- US-A1- 2016 222 649
- Anonymous: "Meetup: Montag, 17. Juli 2017 3D-Druck Materialien im Vergleich | FabLab Winti", , 17 July 2017 (2017-07-17), pages 1-1, XP055915372, Retrieved from the Internet: URL:https://fablabwinti.ch/meetup-montag-1 7-juli-2017-3d-druck-materialien-im-vergle ich/ [retrieved on 2022-04-26]

## Description

### CROSS-REFERENCE TO RELATED APPLICATIONS

This application claims priority to Patent Application No. 201910657453.4, filed with the Chinese Patent Office on July 19, 2019 and entitled "CONTAINER MODULE, CONTAINER ASSEMBLY, AND DATA CENTER".

### TECHNICAL FIELD

This application relates to the technical field of communication devices, and in particular, to a container module according to claim 1.

### BACKGROUND

With the booming of industries such as the Internet, big data, cloud computing, and artificial intelligence, construction demands for data centers have shown explosive growth. A concrete structure is usually adopted in construction of a conventional data center, and has disadvantages such as a long construction cycle, poor flexibility, high costs, and inconvenient maintenance and management. Therefore, the concrete structure cannot meet the demands of the times.

As a new model of data center construction, a prefabricated data center is still under continuous exploration and improvement. Briefly, a modular design concept is adopted for the prefabricated data center, and a container is usually adopted to replace the concrete structure. Data center equipment (such as a server) can be installed in the container. Therefore, the container has obvious advantages of rapid deployment and flexible expansion, and can overcome many disadvantages of conventional civil construction modes. However, there are still many disadvantages during specific application of the conventional prefabricated data center. For example, when a large quantity of containers need to be deployed, the plurality of containers cannot be well matched, resulting in a waste of resources. In addition, because the container has a closed container structure, it is not convenient to wire and install devices in the plurality of containers.
WO 2005/038155 A1 discusses a building module which has an exterior shape generally of a cuboid having side, end, top and bottom faces, and fabricated from metal, the module being hollow and defining a space of a size suitable for occupation by a person. Alternative building modules using shipping containers are also disclosed in CN108729552A and EP3456903A1. In contrast to typical shipping containers WO2010/094459A1 discloses a computer rack according to the state of the art, also suiting as a container module according to the preamble of claim 1.

### SUMMARY

This application provides a container module, a container assembly, and a data center that are easy to install and save materials. The invention is set out in the appended set of claims.

The embodiment of the invention is provided by a container module according to claim 1, including a baseplate assembly and a plurality of columns, where the baseplate assembly includes a base frame and a baseplate fixed on the base frame; the plurality of columns are fixed on the base frame in parallel to each other; and each column has an extension section extending above the baseplate assembly, and/or each column has an extension section extending below the baseplate assembly. Specifically, the base frame in the baseplate assembly may provide a relatively strong stress strength to ensure overall structural strength of the baseplate assembly. The baseplate installed on the base frame may provide an installation surface required by industrial equipment or provide a flat living surface for an occupant. The industrial equipment is used as an example. The industrial equipment may be placed directly on the baseplate, or fixed to the baseplate by using a screw or a rivet, through welding, or the like, so as to improve stability of the industrial equipment and avoid position offset. Certainly, to provide an accommodating space in a vertical direction, in an embodiment provided in this application, the container module further includes a plurality of columns, and the plurality of columns may be vertically or obliquely fixed on the base frame. An upper end of each column may extend above the baseplate assembly, or a lower end of each column may extend below the baseplate assembly. Specifically, each column may have an extension section extending above the baseplate assembly, or each column may have an extension section extending below the baseplate assembly, or each column may have both an extension section extending above the baseplate assembly and an extension section extending below the baseplate assembly.

During specific application, when two container modules are vertically stacked, with support of the columns, a distance between a baseplate assembly at an upper layer and a baseplate assembly at a lower layer can be maintained, so that a vertical space for accommodating industrial equipment is formed between the baseplate assembly at the upper layer and the baseplate assembly at the lower layer.

In some specific implementations, the container module and the baseplate assembly may have various overall outlines.

For example, the overall outline of the container module may be in a rectangular cube structure, a cylindrical structure, or a cube structure in another shape. Correspondingly, the overall outline of the baseplate assembly may be in an approximately rectangular plate-like structure, a circular plate-like structure, or another shape.

For example, the overall outline of the container module is in a rectangular cube structure. The overall outline of baseplate assembly is of an approximately rectangular plate-like structure, four columns may be arranged in the container module, and the four columns may be arranged at four corners of the baseplate assembly. Certainly, in another implementation, there may be more columns, and the columns may alternatively be arranged at side edges or in other positions of the baseplate assembly.

During specific implementation, the baseplate assembly may have various structure forms.

For example, in an embodiment provided in this application, the base frame may include two trusses arranged in parallel to each other. The two trusses are arranged laterally, and the baseplate is fixed on upper sides or lower sides of the two trusses. Specifically, the two trusses being arranged laterally may be understood as a length direction of the trusses being parallel to a horizontal plane, or a length direction of the trusses being parallel to a plate surface of the baseplate.

Specifically, the truss refers to a planar or spatial structure that has a triangular or trapezoidal unit and that includes a pole assembly, and has advantages of saving materials and reducing a structural weight. In an embodiment provided in this application, the truss includes a top chord and a bottom chord that are arranged in parallel, and a plurality of truss webs are connected between the top chord and the bottom chord. Specifically, the truss webs may be vertically connected to the top chord and the bottom chord, or the truss webs may be connected to the top chord and the bottom chord at an inclination angle. The truss webs, the top chord, and the bottom chord are connected to form a plurality of triangular outlines. Such structure arrangement can effectively improve stress performance of the truss, and has advantages of reduced material consumption, a light weight, and the like.

Certainly, to improve structural strength and integrity of the base frame, in some implementations, the two trusses may further be connected.

For example, in an embodiment provided in this application, the two trusses are connected by using a plurality of lower short beams. Specifically, two ends of each lower short beam are respectively connected to two top chords, and each lower short beam is arranged perpendicular to the top chords. Certainly, in another implementation, two ends of each lower short beam may alternatively be respectively connected to two bottom chords, or there are both a lower short beam connected to two top chords and a lower short beam connected to two bottom chords. Certainly, in some specific implementations, the lower short beam may alternatively be connected to two top chords at an inclination angle.

In addition, the two trusses may alternatively be connected by using the baseplate.

Specifically, in an embodiment provided in this application, the baseplate is arranged on an upper side of the base frame and is fixedly connected to the two trusses. Certainly, in another implementation, the baseplate may alternatively be arranged on a lower side of the base frame, the baseplate may be arranged in the middle of the two trusses, or the like.

Certainly, in some specific implementations, to improve connection strength between the baseplate and the base frame and to avoid affecting connection stability between the baseplate and the base frame due to thermal expansion and contraction, the baseplate may be spliced by a plurality of baseplate units.

In addition, to facilitate vertical splicing of a plurality of container modules, in some specific implementations, a first connecting portion may be arranged at the top of the column, and a second connecting portion may be arranged at the bottom of the column. Specifically, when two container modules are vertically stacked, a second connecting portion at the bottom of a column of the container module at the upper layer may be connected to a first connecting portion at the top of a column of the container module at the lower layer.

During specific implementation, a connection manner between the container module at the upper layer and the container module at the lower layer may be welding, screwing, riveting, clamping, or the like.

Because the container module may be directly used in an outdoor environment when actually being used, to improve tightness of the container module or an entire container assembly, a side panel structure may be further arranged on a side surface of the container module or a side surface of the container assembly.

During specific implementation, a side panel may be pre-installed in the container module or may be finally installed on an outer side of the container assembly.

The container assembly or the container module may meet various use requirements.

For example, the container assembly or the container module may be used as a house for people to live in, or used as a factory building or a warehouse for accommodating industrial equipment.

Specifically, an embodiment of this application further provides a data center, including a function device and any one of the foregoing container assemblies. During specific implementation, the function device may include a server, a heat dissipation device, a power generation device, and the like. An appropriate stacking manner may be selected for a plurality of container modules based on an installation requirement of the data center, thereby having relatively high construction flexibility.

### BRIEF DESCRIPTION OF DRAWINGS

FIG. 1 is an application scenario diagram of a container module according to an embodiment of this application;
FIG. 2 is another application scenario diagram of a container module according to an embodiment of this application;
FIG. 3 is a schematic structural diagram of a container module according to an embodiment of this application;
FIG. 4 is a schematic structural diagram of a base frame according to an embodiment of this application;
FIG. 5 is a partially enlarged view of FIG. 4;
FIG. 6 is a schematic structural diagram of a truss web according to an embodiment of this application;
FIG. 7 is a schematic structural diagram of another base frame according to an embodiment of this application;
FIG. 8 is a partially enlarged view of FIG. 7;
FIG. 9 is a cross-sectional view of a lower short beam according to an embodiment of this application;
FIG. 10 is a schematic structural diagram of a baseplate assembly according to an embodiment of this application;
FIG. 11 is a schematic structural diagram of another baseplate assembly according to an embodiment of this application;
FIG. 12 is a schematic structural diagram of a container module according to an embodiment of this application;
FIG. 13 is a partially enlarged view of FIG. 12;
FIG. 14 is a schematic structural diagram of a column according to an embodiment of this application;
FIG. 15 is a composite schematic structural diagram of a container module according to an embodiment of this application;
FIG. 16 is a composite schematic structural diagram of another container module according to an embodiment of this application;
FIG. 17 is a partially enlarged view of FIG. 16;
FIG. 18 is a schematic structural diagram of another container module according to an embodiment of this application;
FIG. 19 is a schematic structural diagram of still another container module according to an embodiment of this application;
FIG. 20 is a schematic structural diagram of a side panel according to an embodiment of this application;
FIG. 21 is a schematic structural diagram of a container assembly according to an embodiment of this application;
FIG. 22 is a schematic structural diagram of another container assembly according to an embodiment of this application; and
FIG. 23 is a schematic structural diagram of a data center according to an embodiment of this application.

### DESCRIPTION OF EMBODIMENTS

To make the objectives, technical solutions, and advantages of this application clearer, the following further describes this application in detail with reference to the accompanying drawings.

For ease of understanding a container module provided in an embodiment of this application, an application scenario of the container module is first described as follows.

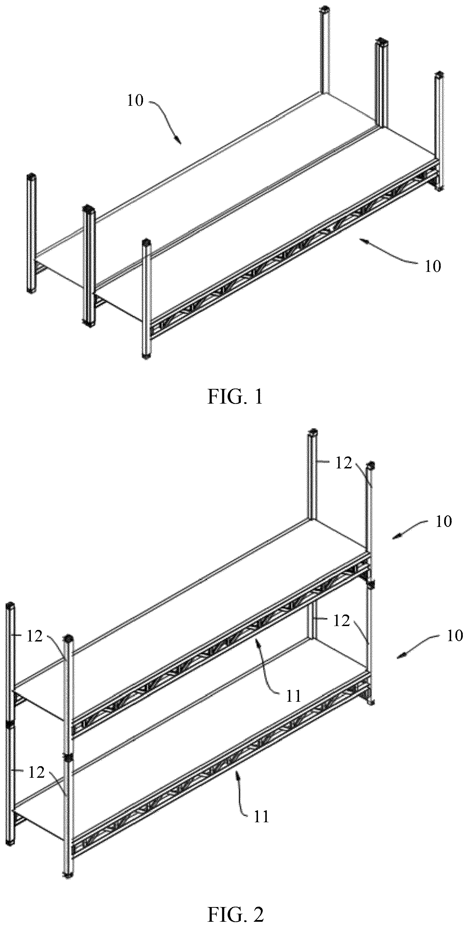

The container module in the embodiment of this application may be directly used in an outdoor environment, used to replace a conventional civil structure or used in combination with a conventional civil structure, and may be used as a house for people to live in, or used as a factory building, a warehouse, or the like for accommodating industrial equipment. In a practical application, a use quantity and position arrangements of container modules may be properly adjusted based on different requirements. For example, as shown in FIG. 1, when a relatively large lateral area is required, a plurality of container modules 10 may be arranged laterally, and the plurality of container modules 10 (only two of which are shown in the figure) may be spliced to each other to form a relatively large accommodating area. Specifically, when the industrial equipment is relatively large in volume or relatively long in length, the plurality of container modules 10 may be arranged laterally to form an accommodating space that has a relatively large lateral space, thereby satisfying an installation requirement of the industrial equipment. Certainly, as shown in FIG. 2, in some cases, the plurality of container modules 10 (only two of which are shown in the figure) may alternatively be stacked vertically to use a land area, or to satisfy different requirements of the industrial equipment. It may be understood that a quantity of container modules 10 stacked vertically, and a quantity of container modules 10 arranged laterally may be two, three, or more.

The container module 10 provided in the embodiment of this application can effectively ensure structural strength and a use function of the container module 10, and has an advantage of reducing material consumption.

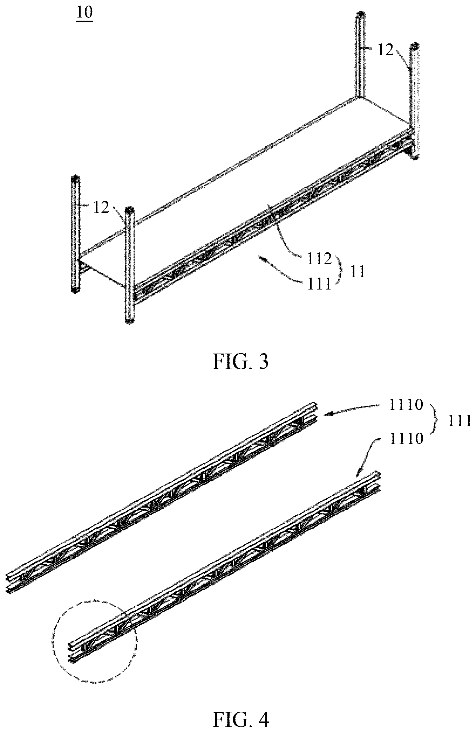

As shown in FIG. 3, in an embodiment provided in this application, the container module 10 includes a baseplate assembly 11 and a plurality of columns 12; the baseplate assembly 11 includes a base frame 111 and a baseplate 112 fixed to the base frame 111; the plurality of columns 12 are fixed on the base frame 111 in parallel to each other, and the plurality of columns 12 are arranged perpendicular or substantially perpendicular to the base frame 111; and each column 12 has an extension section extending above the baseplate assembly 11, and/or each column 12 has an extension section extending below the baseplate assembly 11.

Specifically, the base frame 111 in the baseplate assembly 11 may provide relatively strong stress strength to ensure overall structural strength of the baseplate assembly 11. The baseplate 112 installed on the base frame 111 may provide an installation surface required by the industrial equipment or provide a flat living surface for an occupant. The industrial equipment is used as an example. The industrial equipment may be placed directly on the baseplate 112, or fixed to the baseplate by using a screw or a rivet, through welding, or the like, so as to improve stability of the industrial equipment and avoid position offset. Certainly, to provide an accommodating space in a vertical direction, in an embodiment provided in this application, the container module 10 further includes a plurality of columns 12, and the plurality of columns 12 may be vertically or obliquely fixed on the base frame 111. An upper end of each column 12 may extend above the baseplate assembly 11, or a lower end of each column 12 may extend below the baseplate assembly 11. Specifically, as shown in FIG. 2, when two container modules 10 are stacked vertically, with support of the columns 12, a distance between the baseplate assembly 11 at the upper layer and the baseplate assembly 11 at the lower layer can be maintained, so that a vertical space for accommodating the industrial equipment is formed between the baseplate assembly 11 at the upper layer and the baseplate assembly 11 at the lower layer.

By using the foregoing structural arrangement, open arrangements of an upper part and a side part of the container module 10 can be implemented, thereby improving convenience of installing the industrial equipment 20. In addition, when a plurality of container modules 10 are arranged laterally, a connection operation is also conveniently performed on an adjacent container module 10, and a thorough lateral space can be formed, facilitating placement of industrial equipment with a relatively long length. When the plurality of container modules 10 are stacked vertically, a baseplate assembly 11 of a container module 10 at an upper layer may be used as a top cover of a container module 10 at a lower layer, so that the baseplate assembly 11 of the container module 10 at the upper layer can be used for a plurality of purposes. In addition, material consumption, manufacturing costs, transportation costs, and the like can be reduced.

During specific implementation, the container module 10 may have various overall structures, and each component part may have various structures.

For example, as shown in FIG. 4, in an embodiment provided in this application, the base frame 111 may include two trusses 1110 arranged in parallel to each other.

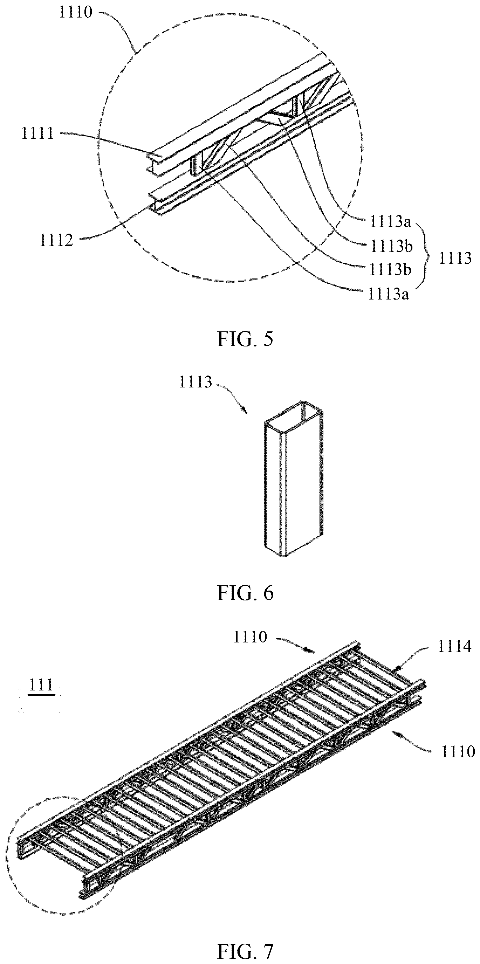

Specifically, the truss 1110 refers to a planar or spatial structure that has a triangular or trapezoidal unit and that includes a pole assembly, and has advantages of saving materials and reducing a structural weight. As shown in FIG. 5, in the embodiment according to the invention provides that the truss 1110 includes a top chord 1111 and a bottom chord 1112 that are arranged in parallel, and a plurality of truss webs 1113 are connected between the top chord 1111 and the bottom chord 1112. Specifically, a truss web 1113a is vertically connected to the top chord 1111 and the bottom chord 1112, and a truss web 1113b is connected to the top chord 1111 and the bottom chord 1112 at an inclination angle. The truss web 1113a, the truss web 1113b, the top chord 1111, and the bottom chord 1112 are connected to form a plurality of triangular outlines. Such structure arrangement can effectively improve stress performance of the truss 1110, and has advantages of reduced material consumption, a light weight, and the like.

During specific implementation, the top chord 1111 and the bottom chord 1112 may use an I-beam structure so that the top chord 1111 and the bottom chord 1112 themselves have relatively strong structural strength and improved tensile strength and flexural strength. Certainly, in another implementation, the top chord 1111 and the bottom chord 1112 may alternatively take a form of a T-beam structure or another structure form. In addition, three, four, or more top chord 1111 and bottom chord 1112 may be arranged in parallel or obliquely in each truss 1110 to improve overall structural strength.

In addition, during specific implementation, the truss web 1113 may have various structure forms. For the embodiment according to the invention provides, that example, as shown in FIG. 6, in the truss web 1113 uses a hollow tube structure, so that the truss web 1113 has relatively strong stress performance and has an advantage of a light weight. In some specific implementations, a cross-sectional shape of the truss web 1113 may be circular (that is, the truss web is a circular tube), rectangular (that is, the truss web is a rectangular tube), or another polygonal structure. In addition, the truss web may alternatively have an I-beam structure, a T-beam structure, or the like.

During specific implementation, the truss web 1113 and both of the top chord 1111 and the bottom chord 1112 may have various connection manners. For example, the truss web 1113 and both of the top chord 1111 and the bottom chord 1112 may be connected through welding, bolting, riveting, and the like.

In an embodiment provided in this application, the base frame 111 includes two trusses 1110 arranged in parallel to each other. To improve structural strength and integrity of the base frame 111, in some implementations, the two trusses 1110 may alternatively be connected.

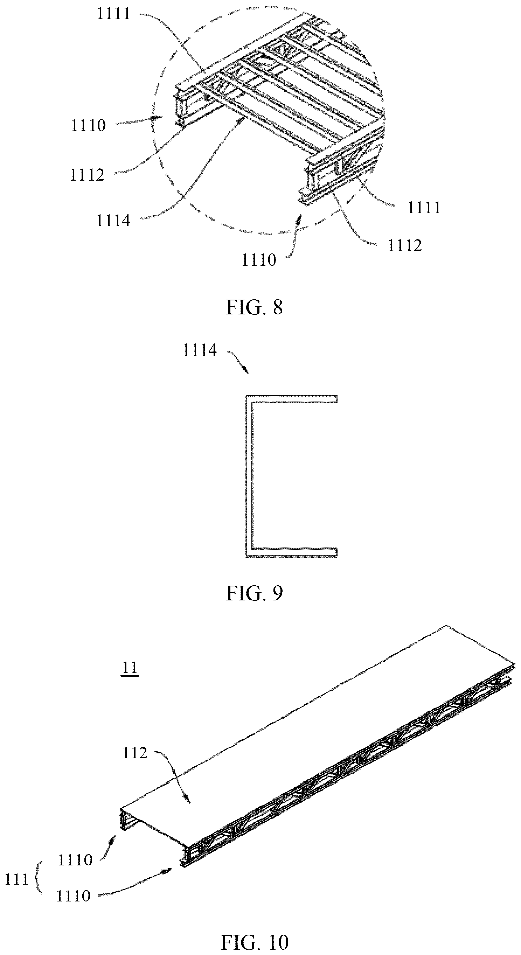

As shown in FIG. 7, in an embodiment provided in this application, the two trusses 1110 are connected by using a plurality of lower short beams 1114. Specifically, as shown in FIG. 8, two ends of each lower short beam 1114 are respectively connected to two top chords 1111, and each lower short beam 1114 is arranged perpendicular to the top chords 1111. Certainly, in another implementation, two ends of each lower short beam 1114 may alternatively be respectively connected to two bottom chords 1112, or there are both a lower short beam 1114 connected to two top chords 1111 and a lower short beam 1114 connected to two bottom chords 1112. Certainly, in some specific implementations, the lower short beam 1114 may alternatively be connected to two top chords 1111 at an inclination angle. The lower short beam 1114 may also have various structure forms. For example, as shown in FIG. 9, in an embodiment provided in this application, the lower short beam 1114 has a U-beam structure. Certainly, in another implementation, the lower short beam 1114 may alternatively have an I-beam structure, a T-beam structure, or the like.

In addition, the two trusses 1110 may alternatively be connected by using the baseplate.

Specifically, as shown in FIG. 10, in an embodiment provided in this application, the baseplate 112 is arranged on an upper side of the base frame 111 and is fixedly connected to the two trusses 1110. Certainly, in another implementation, the baseplate 112 may alternatively be arranged on a lower side of the base frame 111, the baseplate 112 may be arranged in the middle of the two trusses 1110, or the like.

Certainly, in some specific implementations, to improve connection strength between the baseplate 112 and the base frame 111 and to avoid affecting connection stability between the baseplate 112 and the base frame 111 due to thermal expansion and contraction, the baseplate 112 may be spliced by a plurality of baseplate units 1121.

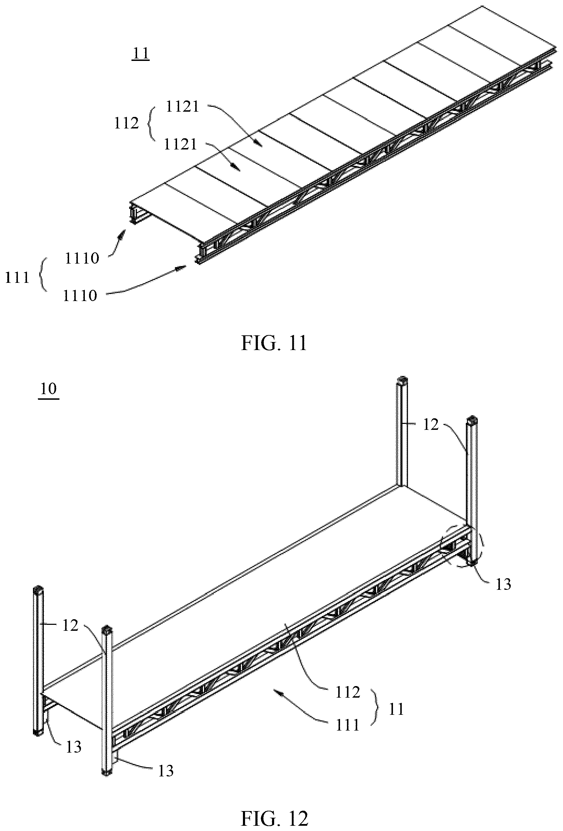

Specifically, as shown in FIG. 11, in an embodiment provided in this application, the baseplate 112 includes a plurality of separate baseplate units 1121, and each baseplate unit 1121 is fixed on the base frame 111.

During specific implementation, each baseplate unit 1121 may be fixedly connected to the truss 1110, may be fixedly connected to the lower short beam (not shown in the figure), or may be fixedly connected to both the truss 1110 and the lower short beam.

Certainly, in some implementations, the baseplate 112 or the baseplate unit 1121 may have a flat plate-like structure, or may have a corrugated or another plate-like structure.

In addition, during specific implementation, the baseplate 112 or the baseplate assembly 11 may have various overall structures.

For example, as shown in FIG. 11, in an embodiment provided in this application, the baseplate 112 as a whole has a rectangular structure. Certainly, in another implementation, the baseplate 112 as a whole may alternatively have a polygonal structure such as a disk or a triangle. Correspondingly, a use quantity of columns 12 and relative positions between the columns 12 and the baseplate assembly 11 may be variously adjusted.

As shown in FIG. 12, in an embodiment provided in this application, the baseplate assembly 11 (or the baseplate 112) as a whole has a rectangular structure, and there are four columns 12, respectively fixed at four corners of the baseplate assembly 11.

During specific implementation, the column 12 may be fixedly connected to the base frame 111 through welding, by using a screw or a rivet, or the like.

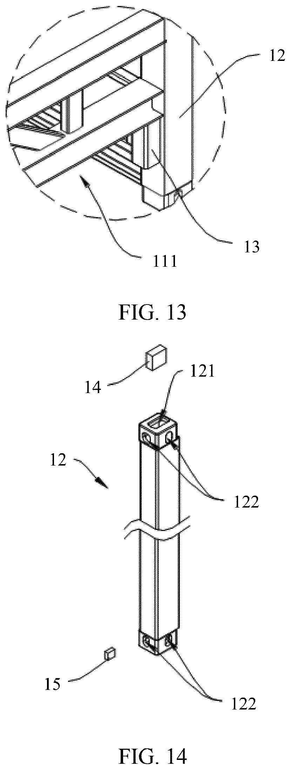

For example, in an embodiment provided in this application, the column 12 may be fixedly connected to the base frame 111 through welding. Specifically, a side part of the column 12 is welded to an end part of the base frame. Certainly, during specific implementation, to improve connection convenience and structural stability between the column 12 and the base frame 111, as shown in FIG. 13, a positioning block 13 may be arranged at a side part of the column 12. When the column 12 and the base frame 111 need to be connected, the base frame 111 may be first lapped on the positioning block 13 to improve positioning accuracy between the column 12 and the base frame 111, and then the column 12 and the base frame 111 may be fixedly connected through welding. It may be understood that because the base frame 111 is lapped on the positioning block 13, the positioning block 13 may further provide some support for the base frame 111 to increase a load capacity of the base frame 111 (or the baseplate assembly 11).

In addition, in consideration that when a plurality container modules 10 are stacked vertically, a lower end of a column 12 of a container module 10 at an upper layer needs to be connected to a upper end of a column 12 of a container module 10 at an lower layer, a lower end of a column 12 may extend slightly below the baseplate assembly 11 to improve connection convenience. For example, when the column 12 at the upper layer is welded to the column 12 at the lower layer in a manner of welding, an operation space is required. Therefore, the lower end of the column 12 may extend slightly below the baseplate assembly 11 to form an operation space, thereby facilitating a welding operation by an operator.

To facilitate precise interconnection between the column 12 of the container module 10 at the upper layer and the column 12 of the container module 10 at the lower layer, in some specific implementations, a positioning structure may be arranged at both of an upper end and a lower end of the column 12.

For example, as shown in FIG. 14, in an embodiment provided in this application, the upper end of the column 12 has a positioning hole 121 that opens upwardly, and the lower end of the column 12 has a positioning hole (not shown in the figure) that opens downwardly. When container modules 10 are stacked vertically, an auxiliary positioning structure 14 may be first inserted into a positioning hole 121 of a container module 10 at a lower layer, and then the auxiliary positioning structure 14 is inserted into a positioning hole of a container module 10 at an upper layer, thereby implementing precise interconnection between the two container modules 10 at the upper layer and at the lower layer. Certainly, in some implementations, the upper end or the lower end of the column 12 may alternatively be formed with a structure of the auxiliary positioning structure 14, to facilitate insertion into the positioning hole at the lower end or the upper end of the column 12, thereby implementing precise interconnection.

In addition, when a plurality of container modules 10 are spliced laterally, to improve interconnection precision between two adjacent container modules 10, in some specific implementations, the side part of the columns 12 may further be provided with a positioning structure.

For example, as shown in FIG. 14, in an embodiment provided in this application, the side part of the column 12 has a positioning hole 122 arranged laterally. When two container modules 10 are interconnected laterally, an auxiliary positioning structure 15 may be first inserted into a positioning hole 122 of one container module 10, and then the auxiliary positioning structure 15 is inserted into a positioning hole 122 of the other container module 10, thereby implementing lateral precise interconnection between the two container modules 10. Certainly, in some implementations, the side part of the column 12 may alternatively be formed with a protruding auxiliary positioning structure to precisely interconnect with a positioning hole 122.

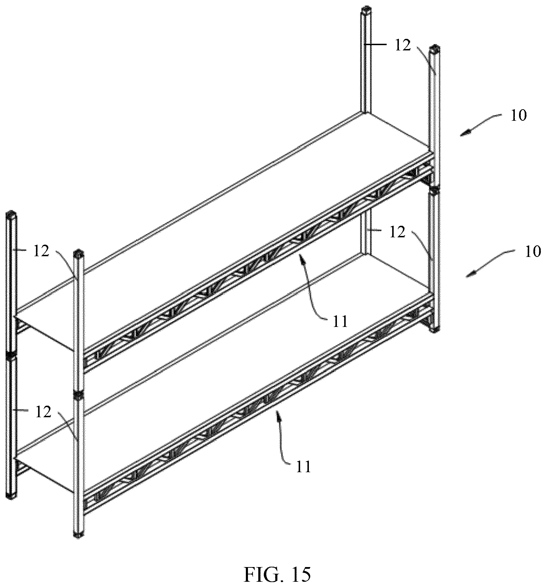

During specific implementation, as shown in FIG. 15, two adjacent container modules 10 may be fixedly connected through welding or by using an auxiliary connecting structure.

For example, in an embodiment provided in this application, after a container module 10 at an upper layer and a container module 10 at a lower layer are interconnected, a lower end of a column 12 of the container module 10 at the upper layer may be welded to an upper end of a column 12 of the container module 10 at the lower layer.

Certainly, in some specific implementations, the container module at the upper layer and the container module at the lower layer may alternatively be connected by using an auxiliary connecting structure such as a bolt or a rivet.

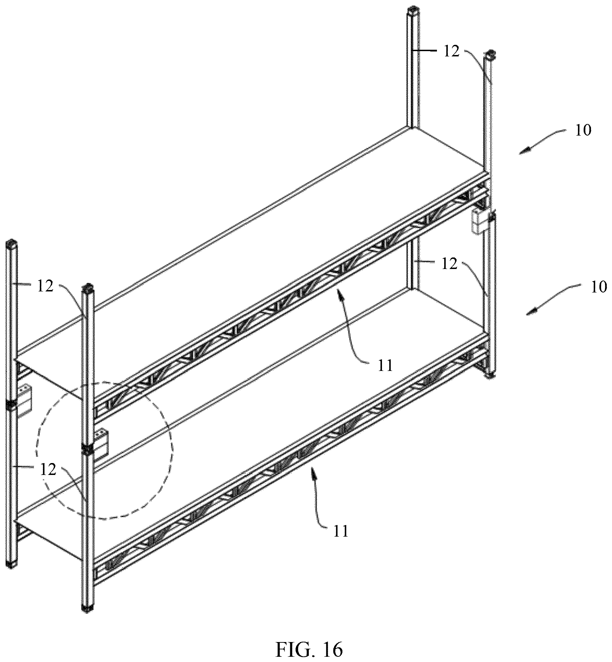

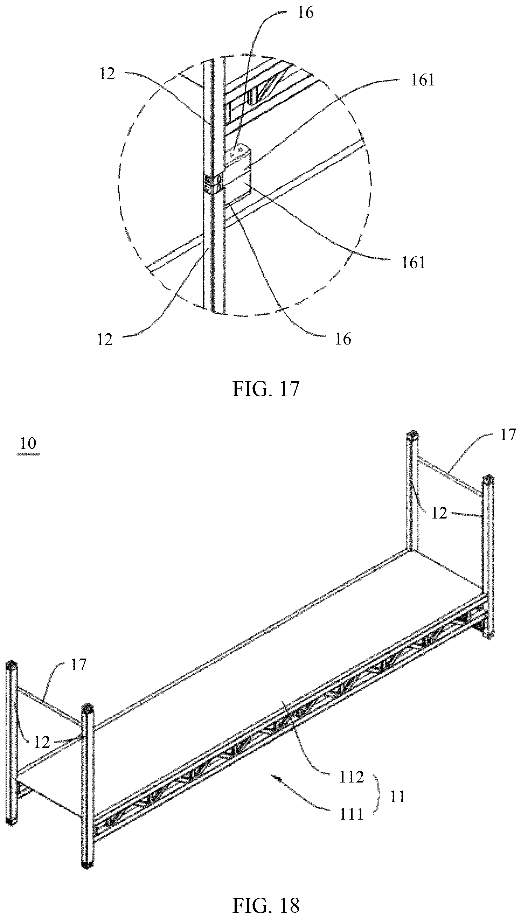

As shown in FIG. 16, in an embodiment provided in this application, the container module at the upper layer and the container module at the lower layer are connected by using bolts. Specifically, as shown in FIG. 17, a connecting plate 16 is arranged near both an upper end and a lower end of a column 12, and the connecting plate 16 is provided with a through-hole for a bolt to penetrate. After the container module 10 at the upper layer and the container module 10 at the lower layer are interconnected, a bolt (not shown in the figure) may be used to penetrate through through-holes of two upper and lower connecting plates 16 and match with a nut to connect the two connecting plates 16, thereby implementing connection of the two container modules 10. Certainly, in some specific implementations, to improve connection strength between the connecting plate 16 and the column 12, a reinforcing plate 161 may be further arranged between the connecting plate 16 and the column 12 to prevent the connecting plate 16 from being bent and deformed, thereby effectively improving connection stability between two adjacent container modules 10.

It may be understood that when a plurality of container modules 10 are interconnected laterally, they may alternatively be fixedly connected through welding or by using an auxiliary connecting structure. Certainly, when two adjacent container modules 10 are connected by using a bolt, the two container modules 10 may alternatively be fixedly connected by arranging the connecting plate 16. It may be understood that the connecting plate 16 may be arranged in various positions.

During specific implementation, an upper end of a column 12 may extend above the baseplate assembly 11 by various lengths. Correspondingly, a lower end of a column 12 may also extend below the baseplate assembly 11 by various lengths. Certainly, for ease of use, upper ends of all columns 12 may be kept flushed, and lower ends of all the column 12 may also be kept flushed, that is, all the columns 12 may extend above the baseplate assembly 11 by a same or approximately same length, and all the columns 12 may extend below the baseplate assembly 11 by a same or approximately same length.

As shown in FIG. 18, in an embodiment provided in this application, the upper end of the column 12 extends above the baseplate assembly 11 by a relatively long length. To improve stress performance of the column 12 and prevent the column 12 from being bent and deformed, in some specific implementations, an upper short beam 17 may be further arranged. Specifically, two ends of the upper short beam 17 may be connected to upper parts of two adjacent columns 12. Certainly, in another embodiment, two ends of the upper short beam 17 may alternatively be connected to the middle or other parts of two adjacent columns 12, or a plurality of upper short beams 17 may be arranged between two adjacent columns 12.

In practical application, a side panel may further be arranged to ensure tightness of the container module 10.

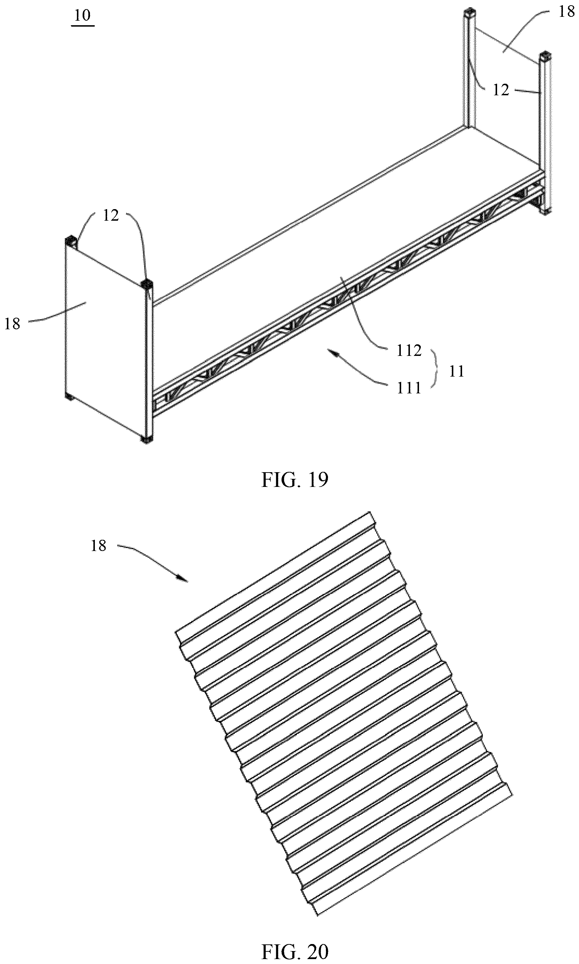

Specifically, as shown in FIG. 19, in an embodiment provided in this application, two opposite side surfaces of the container module 10 are each provided with a side panel 18. Certainly, in another embodiment, a side panel 18 may alternatively be arranged on each side surface or at least one side surface of the container module 10.

During specific implementation, the side panel 18 may have various structure forms.

For example, as shown in FIG. 20, in an embodiment provided in this application, the side panel 18 uses a corrugated structure to have relatively good stress performance. Certainly, in another implementation, the side panel 18 may alternatively have a flat plate-like structure or a structure of another shape. In addition, structures such as a door and a window may be arranged in the side panel 18 to facilitate access of personnel and transportation of devices.

In specific application, the side panel 18 may be pre-arranged in the container module 10, or may be arranged based on actual conditions after a plurality of container modules 10 are interconnected.

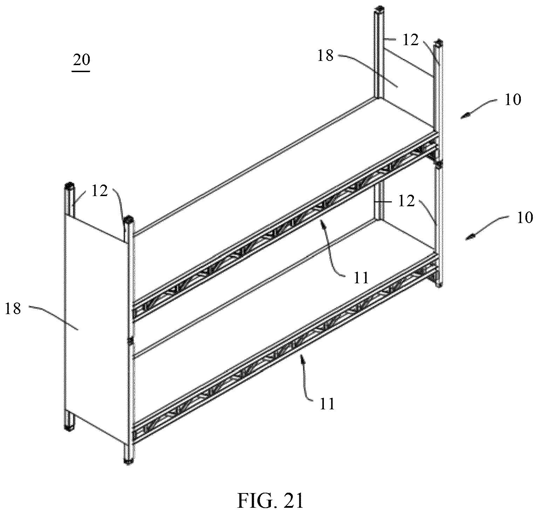

For example, as shown in FIG. 21, a container assembly 20 provided in an embodiment of this application includes a plurality of container modules 10 (two of which are shown in the figure) stacked vertically, and after the plurality of container modules 10 are stacked and fixed, the side panel 18 may be arranged on a side surface that needs to be sealed.

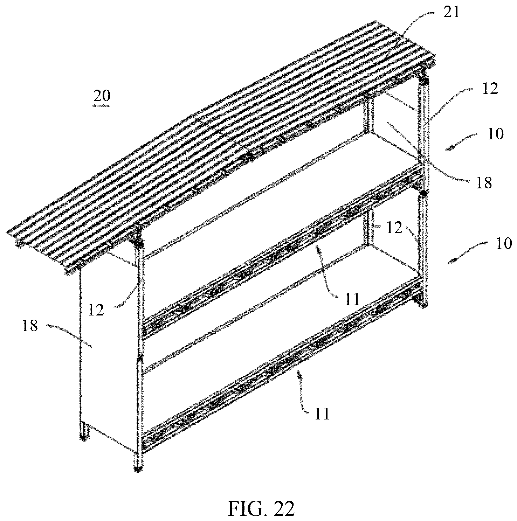

Certainly, because the container assembly 10 is directly exposed to an external environment in actual use, to implement a function such as rain-proofing, as shown in FIG. 22, a top cover structure 21 may further be arranged at the top of an uppermost container module 10 after the plurality of container modules 10 are stacked.

During specific implementation, the top cover structure 21 may be welded to a column 12 of the uppermost container module 10. Certainly, the top cover structure 21 may be fixedly connected to the container module 10 by using a connecting structure such as a bolt or a rivet.

Certainly, in practical application, the container assembly 20 may alternatively be installed with various auxiliary structures based on actual requirements.

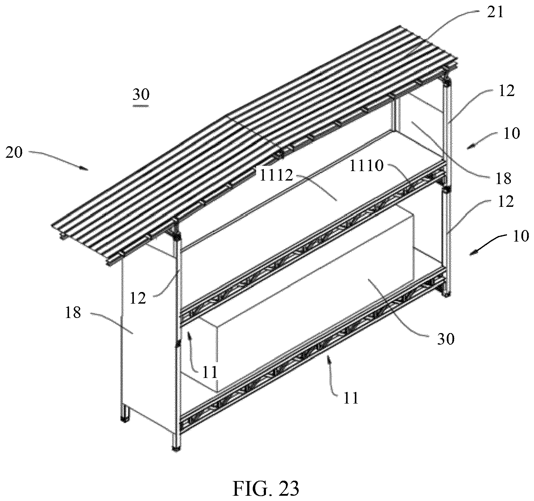

For example, as shown in FIG. 23, in a data center provided in an embodiment of this application, a plurality of server cabinets 30 are installed inside the container assembly 20. In practical application, the server cabinets 30 need to be connected to external devices through various connection cables to implement transmission of electric energy and electrical signals. Therefore, a cable tray for supporting a cable may be installed in the container assembly 20.

Specifically, the cable tray may be installed at the bottom of a container module 10 at an upper layer. Specifically, the cable tray may be connected to the truss 1110 or the baseplate 112 through welding, screwing, riveting, or the like.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application is set forth by the appended claims.

## Claims

1. A container module (10) for accommodating industrial equipment, comprising a baseplate assembly (11) and a plurality of columns (12), wherein
the baseplate assembly (11) comprises a base frame (111) and a baseplate (112) fixed on the base frame (111);
the plurality of columns (12) are fixed on the base frame (111) in parallel to each other; and
each column (12) has an extension section extending above the baseplate assembly (11), and/or each column (12) has an extension section extending below the baseplate assembly (11),
wherein
the base frame (111) comprises two trusses (1110) arranged in parallel to each other; and
the two trusses (1110) are arranged laterally, and the baseplate (112) is fixed on upper sides or lower sides of the two trusses (1110),
wherein each truss (1110) includes a top chord (1111) and a bottom chord (1112) that are arranged in parallel, **characterized in that** a plurality of truss webs (1113) are connected between the top chord (1111) and the bottom chord (1112), and
wherein the truss web (1113) uses a hollow tube structure.

2. The container module (10) according to claim 1, wherein four columns (12) are arranged; and two ends of each truss (1110) are each provided with one of the columns.

3. The container module (10) according to claim 1 or 2, wherein the baseplate assembly (11) further comprises a plurality of lower short beams (1114); and
two ends of each lower short beam (1114) are respectively connected to the two trusses (1110).

4. The container module (10) according to any one of claims 1 to 3, further comprising a plurality of upper short beams (17), wherein
two ends of each of the plurality of upper short beams (17) are respectively connected to two adjacent columns.

5. The container module (10) according to any one of claims 1 to 4, wherein upper ends of the plurality of columns (12) are flushed with each other, and/or lower ends of the plurality of columns (12) are flushed with each other.

6. The container module (10) according to any one of claims 1 to 5, further comprising a side panel (18), wherein
the side panel (18) is at least arranged on one side surface of a polygonal outline enclosed by the plurality of columns (12).

7. A container assembly (20), comprising at least two container modules (10) that are stacked vertically, and/or container modules (10) that are connected laterally, wherein the container module (10) is the container module (10) according to any one of claims 1 to 6.

8. The container assembly (20) according to claim 7, wherein the container assembly (20) comprises at least two container modules (10) that are stacked vertically, and in two vertically adjacent container modules (10),
an upper end of a column in a container module (10) at a lower layer has a first connecting portion;
a lower end of a column in a container module (10) at an upper layer has a second connecting portion; and
the first connecting portion is connected to the second connecting portion.

9. The container assembly (20) according to claim 8, wherein a connection manner between the first connecting portion and the second connecting portion is at least one of welding, screwing, riveting, and clamping.

10. A data center, comprising a function device and the container module (10) according to any one of claims 1 to 6, wherein
the function device is installed on the baseplate (112).

## Patentansprüche

1. Containermodul (10) zum Unterbringen von Industrieanlagen, umfassend eine Grundplattenanordnung (11) und eine Vielzahl von Säulen (12), wobei
die Grundplattenanordnung (11) einen Grundrahmen (111) und eine Grundplatte (112), die an dem Grundrahmen (111) befestigt ist, umfasst;
die Vielzahl von Säulen (12) parallel zueinander an dem Grundrahmen (111) befestigt ist; und
jede Säule (12) einen Erweiterungsbereich aufweist, der sich über der Basisplattenanordnung (11) erweitert, und/oder jede Säule (12) einen Erweiterungsbereich aufweist, der sich unter der Basisplattenanordnung (11) erweitert, wobei der Grundrahmen (111) zwei Träger (1110), die parallel zueinander eingerichtet sind, umfasst; und
die zwei Träger (1110) lateral eingerichtet sind und die Grundplatte (112) an oberen Seiten oder unteren Seiten der zwei Träger (1110) befestigt ist, wobei jeder Träger (1110) einen Obergurt (1111) und einen Untergurt (1112), die parallel eingerichtet sind, beinhaltet, **dadurch gekennzeichnet, dass** eine Vielzahl von Trägerstegen (1113) zwischen dem Obergurt (1111) und dem Untergurt (1112) verbunden sind und wobei der Trägersteg (1113) eine Hohlrohrstruktur verwendet.

2. Containermodul (10) nach Anspruch 1, wobei vier Säulen (12) eingerichtet sind; und
zwei Enden jedes Trägers (1110) je mit einer der Säulen versehen sind.

3. Containermodul (10) nach Anspruch 1 oder 2, wobei die Grundplattenanordnung (11) ferner eine Vielzahl von unteren kurzen Balken (1114) umfasst; und
zwei Enden jedes unteren kurzen Balkens (1114) jeweils mit den zwei Trägern (1110) verbunden sind.

4. Containermodul (10) nach einem der Ansprüche 1 bis 3, ferner umfassend eine Vielzahl von oberen kurzen Balken (17), wobei
zwei Enden jedes der Vielzahl von oberen kurzen Balken (17) jeweils mit zwei angrenzenden Säulen verbunden sind.

5. Containermodul (10) nach einem der Ansprüche 1 bis 4, wobei obere Enden der Vielzahl von Säulen (12) miteinander bündig gemacht werden und/oder untere Enden der Vielzahl von Säulen (12) miteinander bündig gemacht werden.

6. Containermodul (10) nach einem der Ansprüche 1 bis 5, ferner umfassend ein Seitenpaneel (18), wobei
das Seitenpaneel (18) mindestens an einer Seitenoberfläche einer polygonalen Kontur, die durch die Vielzahl von Säulen (12) eingeschlossen wird, eingerichtet ist.

7. Containeranordnung (20), umfassend mindestens zwei Containermodule (10), die vertikal gestapelt sind, und/oder Containermodule (10), die lateral verbunden sind, wobei das Containermodul (10) das Containermodul (10) nach einem der Ansprüche 1 bis 6 ist.

8. Containeranordnung (20) nach Anspruch 7, wobei die Containeranordnung (20) mindestens zwei Containermodule (10), die vertikal gestapelt sind, umfasst und in zwei vertikal angrenzenden Containermodulen (10),
ein oberes Ende einer Säule in einem Containermodul (10) an einer unteren Schicht einen ersten Verbindungsabschnitt aufweist;
ein unteres Ende einer Säule in einem Containermodul (10) an einer oberen Schicht einen zweiten Verbindungsabschnitt aufweist; und
der erste Verbindungsabschnitt mit dem zweiten Verbindungsabschnitt verbunden ist.

9. Containeranordnung (20) nach Anspruch 8, wobei eine Verbindungsweise zwischen dem ersten Verbindungsabschnitt und dem zweiten Verbindungsabschnitt mindestens eine von Schweißen, Schrauben, Nieten und Klemmen ist.

10. Datenzentrum, umfassend eine Funktionsvorrichtung und das Containermodul (10) nach einem der Ansprüche 1 bis 6, wobei
die Funktionsvorrichtung an der Grundplatte (112) angebracht ist.

## Revendications

1. Module de récipient (10) destiné à recevoir un équipement industriel, comprenant un ensemble de plaque de base (11) et une pluralité de colonnes (12), dans lequel
l'ensemble de plaque de base (11) comprend un cadre de base (111) et une plaque de base (112) fixée sur le cadre de base (111) ;
la pluralité de colonnes (12) sont fixées sur le cadre de base (111) parallèlement les unes aux autres ; et
chaque colonne (12) a une section d'extension s'étendant au-dessus de l'ensemble de plaque de base (11), et/ou chaque colonne (12) a une section d'extension s'étendant en dessous de l'ensemble de plaque de base (11), le cadre de base (111) comprenant deux fermes (1110) agencées parallèlement les unes aux autres ; et
les deux fermes (1110) sont agencées latéralement, et la plaque de base (112) est fixée sur les côtés supérieurs ou inférieurs des deux fermes (1110), chaque ferme (1110) comportant une corde supérieure (1111) et une corde inférieure (1112) qui sont agencées en parallèle, **caractérisé en ce qu'**une pluralité d'âmes de ferme (1113) sont reliées entre la corde supérieure (1111) et la corde inférieure (1112), et l'âme de ferme (1113) utilisant une structure de tube creux.

2. Module de récipient (10) selon la revendication 1, dans lequel quatre colonnes (12) sont agencées ; et
deux extrémités de chaque ferme (1110) sont pourvues chacune d'une des colonnes.

3. Module de récipient (10) selon la revendication 1 ou 2, dans lequel l'ensemble de plaque de base (11) comprend en outre une pluralité de faisceaux courts inférieurs (1114) ; et
deux extrémités de chaque faisceau court inférieur (1114) sont respectivement reliés aux deux fermes (1110).

4. Module de récipient (10) selon l'une quelconque des revendications 1 à 3, comprenant en outre une pluralité de faisceaux courts supérieurs (17), dans lequel
deux extrémités de chacun de la pluralité de faisceaux courts supérieurs (17) sont respectivement reliées à deux colonnes adjacentes.

5. Module de récipient (10) selon l'une quelconque des revendications 1 à 4, dans lequel les extrémités supérieures de la pluralité de colonnes (12) sont vidées les unes avec les autres, et/ou les extrémités inférieures de la pluralité de colonnes (12) sont vidées les unes avec les autres.

6. Module de récipient (10) selon l'une quelconque des revendications 1 à 5, comprenant en outre un panneau latéral (18), dans lequel
le panneau latéral (18) est au moins agencé sur une surface latérale d'un contour polygonal entouré par la pluralité de colonnes (12).

7. Ensemble de récipient (20), comprenant au moins deux modules de récipient (10) qui sont empilés verticalement, et/ou des modules de récipient (10) qui sont reliés latéralement, le module de récipient (10) étant le module de récipient (10) selon l'une quelconque des revendications 1 à 6.

8. Ensemble de récipient (20) selon la revendication 7, dans lequel l'ensemble de récipient (20) comprend au moins deux modules de récipient (10) qui sont empilés verticalement, et dans deux modules de récipient (10) adjacents verticalement,
une extrémité supérieure d'une colonne dans un module de récipient (10) au niveau d'une couche inférieure a une première partie de raccordement ;
une extrémité inférieure d'une colonne dans un module de récipient (10) au niveau d'une couche supérieure a une seconde partie de raccordement ; et
la première partie de raccordement est reliée à la seconde partie de raccordement.

9. Ensemble de récipient (20) selon la revendication 8, dans lequel un mode de raccordement entre la première partie de raccordement et la seconde partie de raccordement est au moins l'un parmi le soudage, le vissage, le rivetage et le serrage.

10. Centre de données, comprenant un dispositif fonctionnel et le module de conteneur (10) selon l'une quelconque des revendications 1 à 6, dans lequel
le dispositif de fonction est installé sur la plaque de base (112).
